**Europäisches Patentamt**

(19) **European Patent Office**

**Office européen des brevets**

(11) Veröffentlichungsnummer: **0 130 426**
**B1**

(12) # EUROPÄISCHE PATENTSCHRIFT

(45) Veröffentlichungstag der Patentschrift:
21.09.88

(51) Int. Cl.⁴: **H 04 N 5/92**

(21) Anmeldenummer: **84106769.7**

(22) Anmeldetag: **14.06.84**

(54) System zur Übertragung eines frequenzmodulierten Tonträgers, insbesondere Videorecorder.

(30) Priorität: **01.07.83 DE 3323751**

(43) Veröffentlichungstag der Anmeldung:
**09.01.85 Patentblatt 85/2**

(45) Bekanntmachung des Hinweises auf die Patenterteilung:
**21.09.88 Patentblatt 88/38**

(84) Benannte Vertragsstaaten:
**AT BE CH FR GB IT LI SE**

(56) Entgegenhaltungen:
**EP-A-0 087 303**
**EP-A-0 090 582**
**DE-A-3 206 449**
**US-A-4 388 654**

(73) Patentinhaber: **TELEFUNKEN Fernseh und Rundfunk GmbH, Göttinger Chaussee 76, D-3000 Hannover 91 (DE)**

(72) Erfinder: **Kluth, Hans-Jürgen, Ing.- grad., Weichselstrasse 11, D-7730 VS- Villingen (DE)**
Erfinder: **Schröder, Ernst, Dipl.- Ing., Pinkenburgerstrasse 25D, D-3000 Hannover 51 (DE)**

(74) Vertreter: **Einsel, Robert, Dipl.- Ing., TELEFUNKEN Fernseh und Rundfunk GmbH Göttinger Chaussee 76, D-3000 Hannover 91 (DE)**

**Beschreibung**

Beim Hörrundfunk- und Fernsehrundfunk ist es bekannt, einen oder für Zweisprachenbetrieb oder Stereoton mehrere mit Tonsignalen frequenzmodulierte Tonträger zu übertragen. Es ist auch bekannt (DE-OS 31 13 862), bei einem Videorecorder ein oder mehrere Tonsignale durch Frequenzmodulation von Tonträgern zusammen mit dem Bildträger mit den Videoköpfen auf den Schrägspuren des Magnetbandes aufzuzeichnen. Dadurch wird eine wesentlich höhere Tonqualität erreicht als bei der Aufzeichnung des NF-Tonsignals auf einer parallel zur Bandkante verlaufenden Längsspur.

Zur Erhöhung des Störabstandes bei der Tonwiedergabe ist es bekannt, das NF-Tonsignal vor der Übertragung oder Aufzeichnung mit einem Amplitudenkompressor in der Amplitude zu komprimieren und nach der Übertragung oder Aufzeichnung mit einem Amplitudenexpander wieder entsprechend zu expandieren. Derartige sogenannte Kompandersysteme sind unter den Warenzeichen "Dolby" und "HIGH COM" bekannt und näher beschrieben in der DE-PS 14 87 276 und der DE-PS 24 06 258.

Für eine einwandfreie Tonwiedergabe ist es dabei im allgemeinen notwendig, daß der Kompressor und der Expander entweder beide ausgeschaltet oder beide eingeschaltet sind. Bei einem wirksamen Kompressor vor der Übertragung ohne Expander bei der Wiedergabe oder bei einem nicht vorhandenen Kompressor vor der Übertragung und einem wirksamen Expander bei der Wiedergabe kann es zu Verfälschungen der Tonwiedergabe kommen.

Es ist bekannt, beim Wiedergabegerät einen manuell betätigten Schalter vorzusehen, mit dem der Expander ein- und ausgeschaltet werden kann. Eine derartige manuelle Bedienung ist jedoch für den Bedienenden nachteilig und kann leicht vergessen werden. Außerdem weiß der Bedienende in vielen Fällen, z.B beim Vorliegen einer Videokassette, nicht, ob bei der Aufnahme eine Amplitududenkompression vorgenommen wurde.

Es ist bekannt, derartige Signalvorverzerrungen durch einen zusätzlich übertragenen oder aufgezeichneten Pilotträger zu kennzeichnen, der bei der Wiedergabe zur Betätigung einer Umschaltung ausgenutzt wird. Die Übertragung eines Pilotträgers hat verschiedene Nachteile. Auf der Sendeseite sind zusätzliche Schaltungsmaßnahmen zur Erzeugung des Pilotträgers und auf der Wiedergabeseite frequenzselektiven Mittel zur Auswertung des Pilotträgers erforderlich. Außerdem führt ein Pilotträger als zusätzliches Signal im Gesamt-Übertragungsbereich leicht zu Intermodulationen mit den Trägern für die Ton- und Bildinformation, wodurch Störungen bei der Wiedergabe auftreten können.

Der Erfindung liegt die Aufgabe zugrunde, ohne Übertragung oder Aufzeichnung eines Pilotträgers auf einfache Weise eine selbsttätige Ein- und Ausschaltung des Expanders bei der Wiedergabe zu ermöglichen.

Diese Aufgabe wird durch die im Anspruch 1 beschriebene Erfindung gelöst. Vorteilhafte Weiterbildungen der Erfindung sind in den Unteransprüchen beschrieben.

Bei der erfindungsgemäßen Lösung wird also statt der Verwendung eines zusätzlichen Pilotträgers lediglich das Frequenzband des Tonträgers geringfügig verschoben. Diese Frequenzverschiebung bei der Sendeseite und ihre Auswertung bei der Wiedergabe sind mit einfacheren Schaltungsmitteln möglich als die Erzeugung und Auswertung eines Pilotträgers. Dadurch, daß kein zusätzliches Signal für die Umschaltung übertragen, sondern lediglich das Frequenzspektrum des Nutzsignals um einen geringen Betrag verschoben wird, können auch keine Störungen des Nutzsignals durch ein derartiges zusätzliches Signal auftreten.

Die Erfindung beruht auf folgender Erkenntnis. Die Frequenz des Tonträgers, d.h. die Ruhefrequenz beim Wert null des aufmodulierten NF-Tonsignals, ist an sich mit großer Genauigkeit konstant. Eine geringe Änderung dieser Frequenz stört indessen die Übertragung oder Aufzeichnung durch Frequenzmodulation nicht. Diese Frequenzänderung ist klein gegenüber dem verfügbaren Übertragungsbereich sowohl bei der Rundfunkübertragung als auch bei der Aufzeichnung mit einem Videorecorder. Bei der Wiedergabe wirkt sich die Verschiebung der Trägerlage relativ zur Demodulationskennlinie auch nicht nachteilig aus, weil die Demodulationskennlinie sich in der Praxis über einen größeren Frequenzbereich als den gesamten Hubbereich des Tonträgers erstreckt. Am Ausgang des FM-Demodulators ändert sich bei Änderung der Frequenz des Tonträgers nur der Gleichspannungswert, der für ein NF-Tonsignal ohne Bedeutung ist und unterdrückt werden kann. Andererseits kann aber diese geringe Frequenzänderung des Tonträgers zur Erzeugung einer Stellgröße für die selbsttätige Ein- oder Ausschaltung des Expanders bei der Wiedergabe ausgenutzt werden. Die Frequenz des Tonträgers ist z. B. bei einem Videorecorder mit der Zeilenfrequenz des Fernsehsignals verkoppelt und beträgt ein ganzzahliges Vielfaches der halben Zeilenfrequenz. Dabei reicht eine Frequenzänderung des Tonträgers um die Zeilenfrequenz bereits aus, um bei der Wiedergabe die Stellgröße für die Ein- und Ausschaltung des Expanders zu gewinnen. Dieses kann z. B. durch Zählen der Tonträgerperioden mit einem von den Zeilensynchronimpulsen gesteuerten Zähler erfolgen.

Die Erfindung wird im folgenden anhand der Zeichnung am Beispiel der Aufzeichnung mit einem Videorecorder näher erläutert. Darin zeigen

Fig. 1 ein Blockschaltbild für die Aufnahme,

Fig. 2 ein Blockschaltbild für die entsprechende Wiedergabe,

Fig. 3, 4 zwei Schaltungen zur Gewinnung der Stellgröße und

Fig. 5 ein Diagramm zur Erläuterung der Wirkungsweise der Schaltung nach Fig. 4.

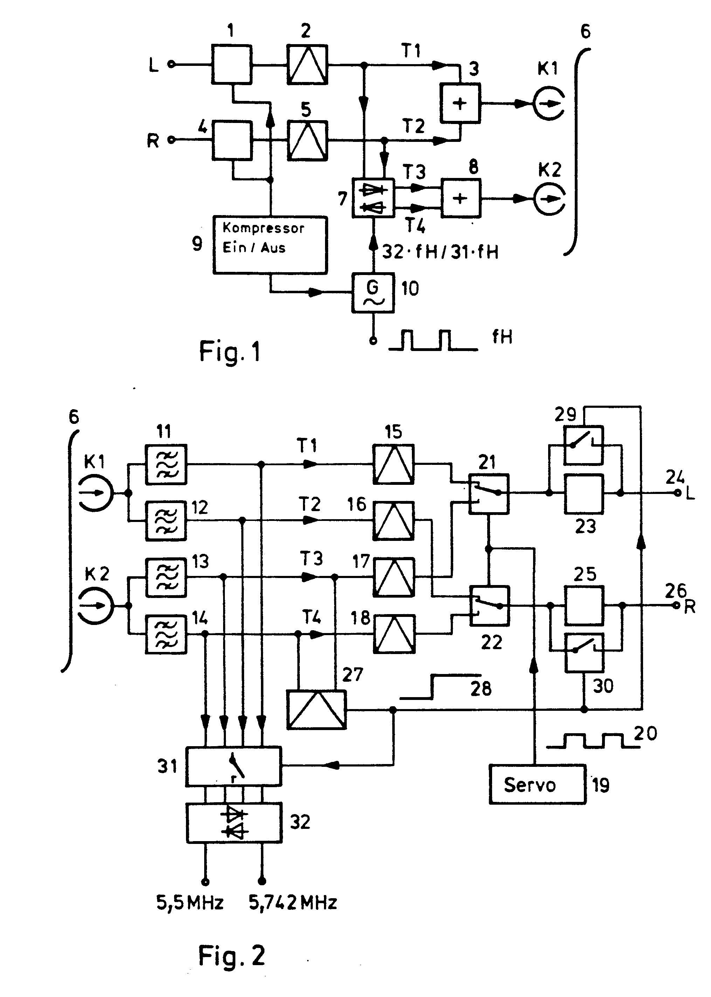

In Fig. 1 wird das den linken Tonkanal darstellende NF-Tonsignal L über den Amplitudenkompressor 1 dem FM-Modulator 2 zugeführt, der einen frequenzmodulierten Tonträger T1 an die Addierstufe 3 liefert. Das den rechten Tonkanal darstellende NF-Tonsignal R wird über den Amplitudenkompressor 4 dem FM-Modulator 5 zugeführt, der einen frequenzmodulierten Tonträger T2 an die Addierstufe 3 liefert. Die beiden Tonträger T1, T2 unterschiedlicher Frequenz am Ausgang der Addierstufe 3 werden mit dem Videokopf K1 auf Schrägspuren des Magnetbandes 6 aufgezeichnet. Die Aufzeichnung der weiteren Signale wie des modulierten Bildträgers, des modulierten Farbträgers und sonstiger Steuersignale sind zur Vereinfachung nicht dargestellt. Die beiden Tonträger T1, T2 werden außerdem der Mischstufe 7 zugeführt und dort in Tonträger T3, T4 in der Frequenz umgesetzt. Die Tonträger T3, T4 werden in der Addierstufe 8 addiert und mit dem Videokopf K2 ebenfalls auf den Schrägspuren des Magnetbandes 6 aufgezeichnet. Die Videoköpfe K1, K2 zeichnen die Tonträger von Halbbild zu Halbbild abwechselnd auf den Schrägspuren auf. Die Tonträger T1 - T4 haben dabei die folgenden Frequenzen:

Halbbild 1:

| Linker Mit Kompression und Expansion | Ohne Kompression und Expansion |
|---|---|
| Kanal:T1 mit 17,0 · fH = 265,625 kHz | |
| | |
| Rechter | unverändert |
| Kanal: T2 mit 32,5 · fH = 507,8125 kHz | |

Halbbild 2:

| Linker | |
|---|---|
| Kanal: T3 mit 49,0 · fH = 765,625 kHz | 48 · fH = 750 kHz |
| | |
| Rechter | |
| Kanal: T4 mit 64,5 · fH = 1007,8125 kHz | 63,5 · fH = 992,1875 kHz |

Die Umschaltung der Tonträgerfrequenzen von Halbbild zu Halbbild hat den Zweck, das Übersprechen zwischen den Tonträgern benachbarter Schrägspuren zu verringern. Dieses ist notwendig, weil in dem von den Tonträgern eingenommenen Frequenzbereich die an sich durch die Azimutwinkel der Videoköpfe bewirkte, zur Verringerung des Übersprechens dienenden Azimutverluste nicht mehr wirksam sind. Diese Umschaltung der Tonträgerfrequenzen ist näher beschrieben in der älteren Patentanmeldung P 33 06 978.

Die Schaltung 9 bestimmt, ob bei der Aufnahme eine Amplitudenkompression mit den Kompressoren 1, 4 vorgenommen wird. Diese Schaltung kann manuell betätigt sein oder auch ein sonstiges Kennsignal auswerten. Die Schaltung 9 schaltet bei Amplitudenkompression bei der Aufnahme die Kompressoren 1, 4 ein. Die Schaltung 9 schaltet außerdem die Frequenz des Mischträgeroszillators 10 um, der durch die zeilenfrequenten Impulse fH synchronisiert ist und einen Mischträger mit einem ganzzeiligen Vielfachen der Zeilenfrequenz erzeugt. Bei eingeschalteten Amplitudenkompressoren 1, 4 erzeugt der Oszillator 10 einen Mischträger mit der Frequenz 32 · fH und bei ausgeschalteten Amplitudenkompressoren 1, 4 einen Mischträger mit der Frequenz 31 · fH. Die aufgezeichneten Tonträger T3, T4 unterscheiden sich also bei ein- und ausgeschalteten Amplitudenkompressoren 1, 4 um die Zeilenfrequenz von 15,625 kHz. Für die Art und die Qualität der Aufzeichnung hat dieses zunächst keine Bedeutung.

In Fig. 2 werden die mit den Videoköpfen K1, K2 abgetasteten Tonträger T1 - T4 mit den obigen Frequenzen den auf diese Frequenzen abgestimmten Bandpässen 11, 14 und FM-Demodulatoren 15 - 18 zugeführt. Mit den von der Servoschaltung 19 mit einer 25 Hz-Schaltspannung 20 gesteuerten Umschaltern 21, 22 erfolgt die notwendige Umschaltung der Tonkanäle zwischen den beiden Videoköpfen K1, K2 jeweils zwischen zwei Halbbildern. Der Ausgang des Umschalters 21 liefert über den dem Amplitudenkompressor 1 angepaßten Amplitudenexpander 23 an der Klemme 24 wieder das Tonsignal L. Der Ausgang des Umschalters 22 liefert über den an den Amplitudenkompressor 4 angepaßten Amplitudenexpander 25 an der Klemme 26 wieder das Tonsignal R.

Die Frequenz der Tonträger T3, T4 ist abhängig davon, ob bei der Aufnahme eine Amplitudenkompression vorgenommen wurde. Die Tonträger T3, T4 werden dem FM-Decoder 27 zugeführt, der die Frequenzen auswertet und die Stellgröße 28 liefert.

Wenn beider Aufnahme eine Amplitudenkompression vorliegt, sind durch die Stellgröße 28 die den Expandern 23, 25 parallel geschalteten Schalter 29, 30 geöffnet, so daß in erwünschter Weise die Expander 23, 25 wirksam sind. Die Stellgröße 28 sperrt ausserdem das mit den Tonträgern T1 - T4 gespeiste Tor 31, das über die Misch- und Umschaltstufe 32 die Ton-ZF-Träger mit den genormten ZF-Frequenzen von 5,5 MHz und 5,742 MHz liefert. Diese Sperrung hat folgenden Zweck. Die Ton-ZF-Träger aus den Ausgängen der Schaltung 32 dienen zur Steuerung eines üblichen Farbfernsehempfängers. Ein solcher Empfänger hat im allgemeinen keinen Amplitudenexpander im Tonkanal. Die Zuführung dieser Tonträger bei vorhandener Kompression würde also eine verfälschte Tonwiedergabe bewirken. Andererseits ist die an die Kompression angepaßte Expansion im Weg der Tonträger nicht möglich, sondern kann nur im Weg der NF-Signale erfolgen. Bei vorhandener Kompression muß also der Farbfernsehempfänger mit den Signalen L, R von den Klemmen 24, 26 nach entsprechender Neumodulation gesteuert werden.

Bei nichtvorhandener Kompression bei der Aufnahme schließt die Stellgröße 28 die Schalter 29, 30, damit die Expander 23, 25 bei der Wiedergabe in erwünschter Weise auch nicht wirksam sind und die Ausgangssignale der Umschalter 21, 22 unverändert auf die Klemmen 24, 26 gelangen. Außerdem steuert die Stellgröße 28 das Tor 31 durchlässig, so daß an den Ausgängen der Stufe 32 die Ton-ZF-Träger für eine Bildwiedergabe mit einem Farbfernsehempfänger erscheinen. Dieses ist jetzt möglich, weil die NF-Tonsignale bei der Aufzeichnung keiner Amplitudenkompression unterworfen sind.

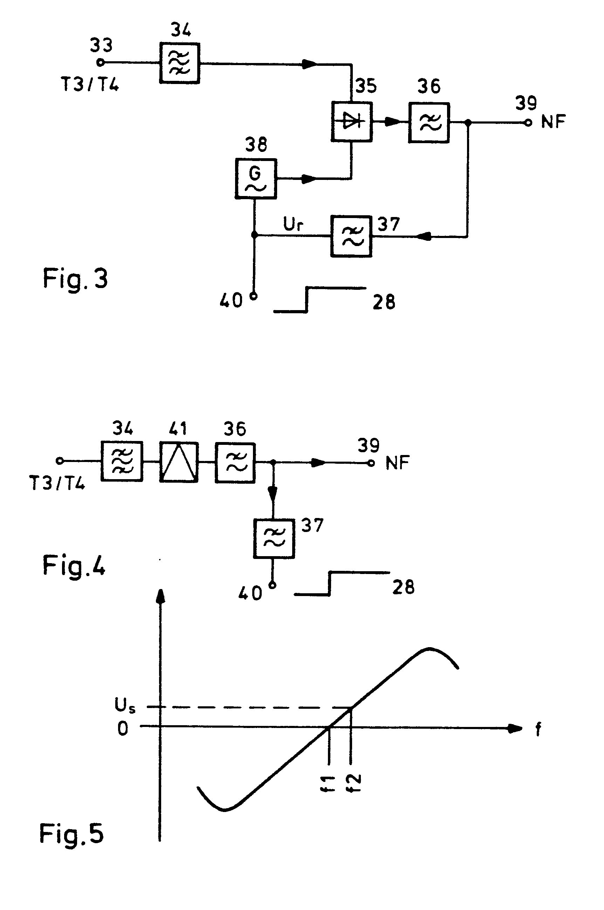

In Fig. 3 wird der Tonträger T3 oder T4 von der Klemme 33 über den Bandpaß 34 der Phasenvergleichsstufe 35 zugeführt, die zusammen mit den Tiefpässen 36, 37 und dem Oszillator 38 eine PLL-Schaltung bildet. Der Tiefpaß 36 liefert an der Klemme 39 das NF-Signal (L oder R) und über den Tiefpaß 37 mit einer entsprechend geringeren Grenzfrequenz von z. B. 10 Hz die Regelspannung Ur für den Oszillator 38, die den Oszillator 38 auf die Frequenz des Tonträgers T3 oder T4 regelt. Die Regelspannung Ur enthält nicht mehr die NF-Frequenzen, sondern entspricht der Mittenfrequenz des Tonträgers T3 oder T4. Diese Regelspannung wird daher an der Klemme 40 gleichzeitig als Stellgröße 28 abgenommen und gemäß Fig. 2 verwertet. Es können auch beide Tonträger T3, T4 parallel ausgewertet und zusammen zur Gewinnung der Stellgröße verwendet werden, um eine größere Sicherheit zu gewährleisten.

In Fig. 4 wird der Tonträger T3 oder T4 über den Bandpaß 34 dem FM-Demodulator 41 zugeführt, der über den Tiefpaß 36 an der Klemme 39 wieder das NF-Signal liefert. Über den Tiefpaß 37 mit der genannten niedrigen Grenzfrequenz wird an der Klemme 40 wieder die Stellgröße 28 gewonnen.

Fig. 5 zeigt die Wirkungsweise der Schaltung nach Fig. 4. Bei nichtvorhandener Kompression hat z. B. der Tonträger die Ruhefrequenz f1, um die herum die Frequenz des Tonträgers entsprechend dem NF-Signal symmetrisch schwankt. Der FM-Demodulator 41 ist auf f1 abgestimmt, liefert also bei f1 an der Klemme 40 einen Spannungswert 0. Dieser dient dann als Stellgröße 28 gemäß Fig. 2 zur Umschaltung auf Betrieb ohne Kompression.

Bei vorhandener Kompression hat der Tonträger die Ruhefrequenz f2, so daß nunmehr nach entsprechender Integration eine Stellgröße Us mit einem endlichen Wert erscheint. Diese wirkt als Stellgröße 28 gemäß Fig. 2 und bewirkt die Umschaltung auf Wiedergabebetrieb bei vorhandener Kompression.

**Patentansprüche**

1. System zur Übertragung eines frequenzmodulierten Tonträgers (T1 - T4), insbesondere Videorecorder, bei dem das NF-Tonsignal (L, R) vor und nach der Übertragung oder Aufzeichnung über einen wahlweise einschaltbaren und ausschaltbaren Amplitudenkompressor (1, 4) bzw. Amplitudenexpander (23, 25) geführt ist, dadurch gekennzeichnet, daß die Frequenz des Tonträgers (T1 - T4) bei Übertragung mit und ohne Amplitudenkompression unterschiedliche Werte hat und bei der Wiedergabe aus der Frequenz des Tonträgers eine Stellgröße (28) zur Ein- und Ausschaltung des Amplitudenexpanders (23, 25) abgeleitet ist.

2. System nach Anspruch 1, dadurch gekennzeichnet, daß bei einem Fernsehsystem mit einem Tonträger (T1 - T4), dessen Frequenz ein ganzzahliges Vielfaches der halben Zeilenfrequenz (fH) ist, der Frequenzunterschied im Tonträger ein ganzzahliges Vielfaches der Zeilenfrequenz ist.

3. System nach Anspruch 2, dadurch gekennzeichnet, daß der Frequenzunterschied gleich der Zeilenfrequenz ist.

4. System nach Anspruch 1, dadurch gekennzeichnet, daß die Stellgröße (28) vom Ausgang eines zur Gewinnung des NF-Tonsignals dienenden FM-Demodulators (35 - 38; 41) über einen das NF-Signal unterdrückenden Tiefpaß (37) abgeleitet ist (Fig. 3, 4).

5. System nach Anspruch 4, dadurch gekennzeichnet, daß der FM-Demodulator einen durch den Tonträger (T3, T4) über eine PLL-Schaltung synchronisierten Oszillator (38) enthält, dessen Phasenvergleichsstufe (35) das NF-Tonsignal und über einen Tiefpaß (37) die Regelspannung (Ur) für den Oszillator (38) und die Stellgröße (28) liefert (Fig. 3).

6. System nach Anspruch 1, dadurch gekennzeichnet, daß bei einem Videorecorder die Stellgröße (28) bei vorhandener Kompression eine Schaltung (32) zur trägerfrequenten Rückummischung des abgetasteten Tonträgers (T1 - T4) auf die genormten Tonträger-ZF-Frequenzen (5,5 und 5,642 MHz) abschaltet (Fig. 2).

**Claims**

1. System for the transmission of a frequency modulated sound carrier (T1 - T4), especially a video recorder, in which the low frequency sound signal (L, R) is conveyed, before and after the transmission or recording, by way of an amplitude compressor (1, 4) or amplitude expander (23, 25) which can be switched selectively into or out of operation, characterized in that the frequency of the sound carrier (T1 - T4) has different values upon transmission with and without amplitude compression and upon the reproduction a control magnitude (28) is derived from the frequency of the sound carrier for the purpose of switching in or out the amplitude expander (23, 25).

2. System according to claim 1, characterized in that in the case of a television system having a sound carrier (T1 - T4), of which the frequency is an integral multiple of the half line frequency (fH), the frequency difference in the sound carrier is an integral multiple of the line frequency.

3. System according to claim 2, characterized in that the frequency difference is equal to the line frequency.

4

**0 130 426**

4. System according to claim 1, <u>characterized in that</u> the control magnitude (28) is taken from the output of an FM-demodulator (35 - 38; 41), serving for the generation of the low frequency sound signal, by way of a low pass filter (37) for suppressing the low frequency signal (Fig 3, 4).

5. System according to claim 4, <u>characterized in that</u> the FM-demodulator includes an oscillator (38) synchronised by the sound-carrier (T3,T4) through a PLL-circuit, the phase comparison stage (35) of which oscillator delivers the low-frequency sound signal and by way of a low pass filter (37), the control voltage (Ur) for the oscillator (38), and the control magnitude (28), (Fig 3).

6. System according to claim 1, <u>characterized in that</u> in the case of a video recorder, if there is compression, the control magnitude (28) switches off a circuit (32) for the carrier frequency reactive mixing of the reproduced sound carrier (T1 - T4) on the standard intermediate frequencies (5.5. and 5.642 MHz) (Fig 2).


**Revendications**

1. Système pour la transmission d'une porteuse son (T1 à T4) modulée en fréquence, en particulier un magnétoscope, dans lequel le signal acoustique B. F. (L, R) passe, avant et après la transmission ou l'enregistrement, respectivement par un compresseur d'amplitude (1, 4) et par un expanseur d'amplitude (23, 25), qui peuvent être à volonté mis en ou hors-circuit, <u>caractérisé en ce que</u> la fréquence de la porteuse son (T1 à T4) présente des valeurs différentes lors de la transmission avec et sans compression d'amplitude et que, lors de la restitution, il est tiré de la fréquence de la porteuse son une grandeur de commande (28) pour la mise en circuit et la mise hors-circuit de l'expanseur d'amplitude (23, 25).

2. Système selon la revendication 1, <u>caractérisé en ce que</u>, dans le cas d'un système de télévision, avec une porteuse son (T1 à T4) dont la fréquence est un multiple entier de la demifréquence de ligne (fH), la différence de fréquences dans la porteuse son est un multiple entier de la fréquence de ligne.

3. Système selon la revendication 2, <u>caractérisé en ce que</u> la différence de fréquences est égale à la fréquence de ligne.

4. Système selon la revendication 1, <u>caractérisé en ce que</u> la grandeur de commande (28) est envoyée, - de la sortie d'un démodulateur FM (35 - 38, 41), fournissant le signal acoustique B.F. -, à un filtre passe-bas (37) filtrant le signal B.F. (figures 3, 4).

5. Système selon la revendication 4, <u>caractérisé en ce que</u> le démodulateur FM comporte un oscillateur (38), synchronisé par la porteuse son (T3, T4) sur un circuit PLL, oscillateur dont l'étage comparateur de phases (35) délivre le signal acoustique B.F. et, par l'intermédiaire d'un filtre passe-bas (37), la tension de régulation (Ur) pour l'oscillateur (38) et la grandeur de commande (28) (figure 3).

6. Système selon la revendication 1, <u>caractérisé en ce que</u>, dans le cas d'un magnétoscope, la grandeur de commande (28), en présence d'une compression, ouvre un organe de commutation (32) pour le rétro-mélange en fréquence porteuse de la porteuse son lue (T1 à T4) sur les fréquences intermédiaires normalisées des porteuses son (5,5 et 5,642 MHz) (figure 2).

Fig. 1

Fig. 2

Fig. 3

Fig. 4

Fig. 5